(19) Europäisches Patentamt
European Patent Office
Office européen des brevets

(11) Publication number: 0 000 786 A1

(12) EUROPEAN PATENT APPLICATION

(21) Application number: 78100639.0

(22) Date of filing: 09.08.78

(51) Int. Cl.$^2$: F 25 B 23/00, F 28 D 15/00, H 01 L 23/42, H 01 F 27/18

(30) Priority: 12.08.77 JP 96018/77

(43) Date of publication of application: 21.02.79 Bulletin 79/4

(84) Designated contracting states: DE FR

(71) Applicant: Hitachi, Ltd
1-5-1, Marunouchi
Chiyoda-ku Tokyo(JP)

(72) Inventor: Okada, Sadayuki
821-7 Ichege Katsuta
Ibaraki(JP)

(72) Inventor: Sonobe, Hisao
2570-18 Tsuda Naka-machi, Naka-gun
Ibaraki(JP)

(74) Representative: Schiff, Karl Ludwig et al,
Patentanwälte Schiff, v. Füner, Strehl, Schübel-Hopf, Ebbinghaus, Finck Mariahilfplatz 2-3
D-8000 München 90(DE)

(54) **Closed type boiling cooling apparatus.**

(57) A closed type boiling cooling apparatus for cooling a heat generating member (10) by utilizing the latent heat of vaporization of a boiling refrigerant (8a) comprises a cooling vessel including an evaporator section (1) and a condenser section (3). A liquid refrigerant reservoir (6) is enclosed at its upper opening portion with an expansible member (7) and is connected with the cooling vessel by means of a condenser pipe (5). The cooling vessel and the condenser pipe (5) are filled with the boiling refrigerant (8a) when no cooling operation is performed. When cooling operation is initiated the boiling refrigerant (8a) is changed into gaseous state (8c) and then led into the condenser pipe (5) which serves to liquefy the gasified refrigerant (8a) and feed it into the liquid refrigerant reservoir (6). The expansible member (7) is adapted to expand in response to the change in the amount of the liquid refrigerant (8b) led into the reservoir (6) so that the internal pressure of the cooling vessel can be maintained substantially constant.

FIG. 1b

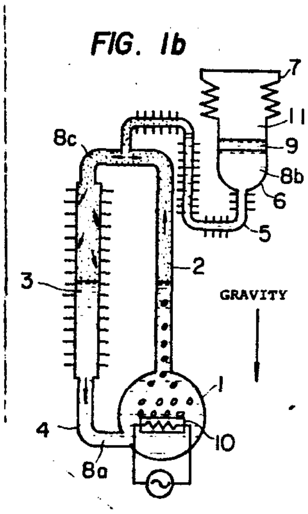


EP 0 000 786 A1

Croydon Printing Company Ltd.

# CLOSED TYPE BOILING COOLING APPARATUS

This invention relates to a boiling cooling apparatus for cooling a heat generating member such as a semiconductor, a transformer or a rotary machine, by utilizing the latent heat of vaporization of a boiling refrigerant, and more particularly to a closed type boiling cooling apparatus including a liquid refrigerant reservoir enclosed at its upper opening portion with an expansible member so as to maintain the inside of a cooling vessel at atmospheric pressure.

A boiling cooling apparatus of the prior art essentially comprises a sealed cooling vessel including an evaporator containing a boiling refrigerant in which a heat generating member is submerged and a condenser section for liquefying a gasified refrigerant. The internal pressure of the cooling vessel may vary depending on the temperature of the boiling refrigerant which varies greatly if there is a change in the ambient temperature or the amount of heat generated by the heat generating member. When, for example, $C_2Cl_3F_3$ (Freon R-113), which is one of halogenated hydrocarbons, is used as a boiling refrigerant, the internal pressure of the cooling vessel varies from 0.15 bar to 4.6 bar as the temperature of the refrigerant changes from $0^oC$ to $100^oC$. Under such condition that the internal pressure of the cooling vessel is lower than the atmospheric pressure (1.053 bar), a non-condensable gas, such as air, will invade the cooling vessel and greatly lower

the performance of the condenser section. This will make it difficult for the cooling vessel to achieve the desired cooling effect, thereby causing overheating of, or damage to, the heat generating member. On the other hand, if the internal pressure of the cooling vessel is higher than the atmospheric pressure, the boiling refrigerant will escape from the cooling vessel to the outside. This will also make it difficult for the cooling vessel to effect cooling satisfactorily.

Accordingly, in the prior art apparatus, it has been considered important to keep the cooling vessel airtight. As a matter of fact, however, the provision of a completely airtight seal to the cooling vessel is not easy even if up-to-date technology is utilized.

In order to solve the above mentioned problem, a different approach was proposed in the United States Application No. 721, 409 which had been assigned to the same applicant as this patent application. The prior application discloses an open-type boiling cooling apparatus including a liquid refrigerant reservoir open at its upper end and connected at its lower portion to a cooling vessel by means of a communicating condenser pipe. A condenser section of the cooling vessel and the communicating pipe are completely filled with the refrigerant in its liquid state when no cooling operation is effected. The liquid refrigerant reservoir contains, for the purpose of preventing effusion of the boiling refrigerant, a sealing liquid immiscible with the boiling refrigerant and having a lower specific gravity than the boiling refrigerant.

This apparatus operates in such a manner that, in proportion to the volume of the heat generated by a heat generating member, the boiling refrigerant can be shifted into the reservoir to provide the condenser section with a greater volume for gaseous refrigerant, with the result that the performance of the condenser section can be automatically accomodated in response to the volume of

heat generated and the temperature of the boiling refrigerant can be maintained at its boiling point.

The structure of the apparatus mentioned above provides the advantage that, during the cooling operation, the cooling vessel is always maintained at the atmospheric pressure without regard to changes in the amount of heat generated by the heat generating member. Because of this advantage, the cooling vessel is not required to be airtight.

As stated before, the liquid regrigerant reservoir contains the sealing liquid for preventing the refrigerant from effusion or evaporation. It has been observed, however that some amount of the refrigerant is gradually wasted over a long period of time. One of the causes is considered to reside in that some refrigerant is dissolved in the sealing liquid and then evaporated into air. The waste of the boiling refrigerant lowers the performance of the cooling function.

Furthermore, the open-type boiling cooling apparatus is disadvantageous in that the boiling refrigerant tends to flow out when the cooling vessel is tilted or inversed during transport. In case the cooling apparatus is transported by car, train or the like, the refrigerant and the sealing liquid tend to flow out due to vibrations.

As will be understood from the above description, although the open-type boiling cooling apparatus disclosed in the prior application has the advantage that the cooling vessel can always operate at atmospheric pressure, it has a drawback in that boiling refrigerant will be wasted in the event that the cooling vessel is tilted, inversed or vibrated.

On the other hand, another cooling system utilizing the latent heat of vaporization is disclosed in U.S. Patent No. 3, 682,237. This patent teaches a cooling system which basically consists of a metal tank sealed with a cover and connected to radiators. The radiators

communicate through a pipe with an inflatable bag. This structure is a closed system, i.e. there is no connection between the inside of the system and the atmosphere surrounding the system so that no refrigerant flows out of the cooling tank even if it is tilted or vibrated. In this system, an air exit is located at the top of the radiator in which the vapor rises from the bottom so that the air tends to float on top of the vapor. As a matter of fact, however, mixing of vapor and air occurs inevitably in the radiator. It is, therefore, difficult for this system to provide a cooling effect of high efficiency.

The object of this invention is to provide an improved cooling apparatus which is constructed to remove drawbacks mentioned above.

More specifically, one of the objects of this invention is to provide a boiling cooling apparatus which operates at atmospheric pressure at all times during cooling.

Another object of this invention is to provide a closed-type boiling cooling apparatus in which the gaseous refrigerant is not in direct contact with air so that the waste of the refrigerant can extremely be reduced.

A further object of this invention is to provide a closed-type boiling cooling apparatus which is safe with respect to vibration, tilting and inversion of the cooling vessel.

In order to achieve these objects, one of the features of this invention resides in that there is provided a liquid refrigerant reservoir sealed at an upper opening portion with an expansible member such as bellows and connected with a cooling vessel through a communicating pipe.

Another feature of this invention is that the cooling vessel and the communicating pipe are completely filled with the liquid refrigerant when no cooling or only slight cooling of a heat generating member is effected and that the liquid refrigerant reservoir is adapted to receive the liquid refrigerant when the cooling operation is performed so as to secure a greater space for gaseous refrigerant in a condenser section.

A further feature of this invention is that the communicating pipe includes a condenser pipe having a down-flow portion through which the refrigerant flows downwardly from the cooling vessel to the reservoir so that the refrigerant which has been changed into its gaseous state in the cooling vessel does not reach the reservoir in the gaseous state, but reaches the same after liquefaction. This feature serves to prevent the gaseous refrigerant from direct contact with air.

A further feature of the invention resides in that the liquid refrigerant reservoir contains a sealing liquid having a lower specific gravity than the boiling refrigerant and being immiscible with the boiling refrigerant so as to prevent the refrigerant from evaporation.

Other objects and features of this invention will become more clearly apparent from the following detailed description of preferred embodiments when read in conjunction with the accompanying drawings . In the drawings:

Fig. 1a and Fig. 1b are schematic views of the closed-type boiling cooling apparatus showing an embodiment of this invention; and

Fig. 2 to Fig. 6 are schematic views showing other embodiments of this invention.

Referring to Fig. 1a and Fig. 1b, the closed-type boiling cooling apparatus comprises an evaporator 1, a gas pipe 2, a condenser 3, a return pipe 4, a communicating pipe 5, a liquid refrigerant reservoir 6 and an expansible member 7. Reference numerals 8a and 8b designate a refrigerant in its liquid state which is a halogenated hydrocarbon.

The halogenated hydrocarbon may be selected from the group of halogenated hydrocarbons comprising carbon tetrachloride ($CCl_4$, Freon R-10), 1,2-difluorotetrachloroethane ($CCl_2F.CCl_2F$, Freon R-112), 1,1,2-trichlorotrifluoroethane

($CCl_2FCClF_2$, Freon R-113), 1-chloro-1,2-dibromo-1,2,2-trifluoroethane ($CBrClF.CBrF_2$, Freon R-113B2), 1,2-dibromotetrafluoroethane ($CBrF_2CBrF_2$, Freon R-114B2), 1,1,1-trichloroethane ($CCl_3CH_3$, Freon-R140), 1,2-dichlorofluoroethane ($CH_2ClCHClF$, Freon R-141), 1,1,1-trichloropentafluoropropane ($CCl_3CF_2CF_3$, Freon R-215), 1,2-dichlorohexafluorocyclobutane (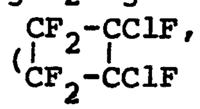 Freon R-C316), 2,3-dichloro-octafluorobutane ($CF_3CFClCFClCF_3$, Freon R-318), cyclic-$C_6F_{12}O$ (FLUORINERT FC-78 made by Minnesota Mining and Manufacturing Company of the U.S.A.), $C_4HF_{11}O$ (Freon E1 made by E.I. du Pont de Nemours and Company of the U.S.A.), perfluoro-n-hexane ($C_6F_{14}$, FLUTEC PP1 made by Imperial Smelting Company of Great Britain).

Reference numeral 8c designates the refrigerant in its gaseous state, 9 a liquid for sealing the refrigerant in the liquid refrigerant reservoir 6 and 10 a heat generating member. The arrows indicate the directions in which the refrigerant flows.

In the evaporator 1, the liquid refrigerant 8a boils and is changed into the gaseous refrigerant 8c, and the heat generating member 10 is cooled by the latent heat of vaporization of the liquid refrigerant 8a. The gaseous refrigerant is led through the gas pipe 2 to the condenser 3 where the gaseous refrigerant is condensed and liquefied. When the gaseous refrigerant 8c is condensed and changed back to the liquid state, the latent heat of liquefaction of the gaseous refrigerant 8c is transmitted to an external coolant or to the air outside the apparatus. The refrigerant 8a which has been changed back to liquid at the condenser 3 is returned through the return pipe 4 to the evaporator 1. The condenser pipe 5 connects the gas pipe 2 to the liquid refrigerant reservoir 6 and is provided with a downflow portion through which the refrigerant is permitted to flow downwardly from the gas pipe 2 to the reservoir 6. In other words, the condenser pipe has a

first end terminating at the upper portion of the gas pipe 2 and a second end terminating at the bottom portion of the reservoir 6, the second end being disposed at a position below the first end. This downward flow portion of the condenser pipe 5 serves to provide important functions. One of the functions is to enable a large amount of the gaseous refrigerant to be led into the condenser 3 rather than the reservoir 6 by virtue of the phenomenon that the gaseous refrigerant is lighter than the liquid refrigerant and tends to flow upwards.

Another function is to prevent the gaseous refrigerant 8c from directly entering the liquid refrigerant reservoir 6. This is because the gaseous refrigerant does not readily flow downwardly through the liquid refrigerant. The liquid refrigerant reservoir 6 is provided for storing the liquid refrigerant 8b which does not directly take part in the cooling operation.

An expansible member 7 such as a bellows is provided to enclose an upper opening portion of the reservoir 6 with an appropriate volume of space therein. The expansible member 7 is adapted to expand depending upon the amount of the liquid refrigerant led into the reservoir 6 so that the inside of the cooling vessel can be always maintained at atmospheric pressure without regard to the movement of the liquid refrigerant entering into, or discharging from, the reservoir 6. The liquid refrigerant 8a has a boiling point which is equal to the temperature to which the heat generating member 10 is intended to be cooled. 8c shows a refrigerant which has been gasified from the liquid refrigerant 8a, while 8b designates a refrigerant which has been again liquefied from the gaseous refrigerant 8c. The heat generating member 10 may be, for example, a semiconductor, a transformer or other electrical equipment.

This liquid refrigerant reservoir 6 further contains a sealing liquid 9 which is immiscible with the liquid

refrigerant 8b, has a specific gravity which is lower than that of the liquid refrigerant 8b, and does not readily evaporate. The sealing liquid 9 may be water or an aqueous solution of at least one material selected from the group consisting of polyhydric alcohols including ethylene glycol ($CH_2OHCH_2OH$), diethylene glycol ($HOCH_2CH_2OCH_2CH_2OH$), triethylene glycol ($HOCH_2CH_2OCH_2CH_2OCH_2CH_2OH$), 1,4-butanediol ($HO(CH_2)_4OH$), and glycerin ($HOCH_2CHOHCH_2OH$); monosaccharides including D-glucose, D-xylose and D-galactose; polyvinyl alcohols; and polysaccharides having glucose units, such as starch, glycogen and cellulose. The sealing liquid 9 is used to prevent spontaneous evaporation of the liquid refrigerant 8b into the air or inactivated gas 11. The gas 11 is adapted to follow the movement of the expansible member 7.

The term "cooling vessel" is defined here as a vessel in which the evaporator 1, gas pipe 2, condenser 3, and return pipe 4 are connected such that the refrigerant can be circulated. In the present invention, the liquid refrigerant reservoir 6 and the expansible member 7 are designed to be able to contain at least the sum of the volume of the liquid refrigerant 8b which should be discharged from the cooling vessel when the condenser 3 functions at 100 % efficiency, and the volume of the sealing liquid 9. The minimum quantity of the liquid refrigerant charged into the cooling vessel should be sufficiently large to fill the entire cooling vessel and the entire condenser pipe 5 so that the sealing liquid 9 is at the bottom of the reservoir 6 when the expansible member 7 is in the least expanded state.

In operation, when the amount of heat generated by the heat generating member is zero, the liquid refrigerant does not boil and no gaseous refrigerant is produced. Thus, as shown in Fig. 1a, the liquid refrigerant 8 fills the cooling vessel, the condenser pipe 5, and the bottom

portion of the reservoir 6. Under this condition, the expansible member 7 is compressed such that the internal pressure of the cooling vessel is substantially equal to atmospheric pressure. Precisely stated, the bottom of the cooling vessel is at the highest pressure which is equal in value to atmospheric pressure plus the pressure of the liquid column.However, in case the cooling vessel is of small size, the pressure of the liquid column is negligible, so that the internal pressure of the cooling vessel can be regarded as being equal to atmospheric pressure.

At the initial stage of heat generation by the heat generating member 10, the liquid refrigerant does not immediately boil but flows in the liquid state in the directions indicated by the arrows in Fig. 1a. By this natural convection, however, cooling is not effected satisfactorily so that the temperature of the liquid refrigerant 8 rises. When the temperature of the liquid refrigerant becomes equal to the saturation temperature at atmospheric pressure, i.e. boiling point of the refrigerant, vigorous boiling of the liquid refrigerant occurs on the surface of the heat generating member 10 and the liquid refrigerant is changed into the gaseous refrigerant 8c as shown in Fig. 1b. This results in a rise in the internal pressure of the cooling vessel, so that the liquid refrigerant 8a and the gaseous refrigerant 8c move through the condenser pipe 5 toward the reservoir 6 which is at lower pressure than the cooling vessel. At this time, the gaseous refrigerant 8c is cooled and liquefied before reaching the reservoir 6. In response to the amount of liquid refrigerant entering the reservoir 6, the expansible member 7 expands to the extent that the cooling vessel is kept at substantially atmospheric pressure.

The body of the liquid refrigerant 8a that has moved to the reservoir 6 in this way is designated as the

liquid refrigerant 8b. The quantity of the liquid refrigerant 8b may vary depending upon the heat generated by the heat generating member 10, the boiling point of the refrigerant and the temperature of the external coolant of the condenser 3. If the boiling point and the temperature of the external coolant of the condenser 3 are constant, the quantity of the liquid refrigerant will vary depending upon the amount of generated heat alone. In this case, equilibrium will be established in the apparatus when a sufficiently large space is secured for the gasified refrigerant 8c or a sufficiently large area is secured for the condensing action of the condenser 3 in the cooling vessel to enable the cycle of boiling and condensation to be initiated and repeated as indicated by the arrows in Fig. 1b without further rise in the temperature of the liquid refrigerant 8a. At this time, the temperature of the liquid refrigerant 8a is substantially the same as its boiling point, and the internal pressure of the cooling vessel is substantially equal to atmospheric pressure.

In Fig. 1b, only one-half portion of the condenser 3 is shown as functioning effectively. At this time, the amount of heat generated by member 10 is half the allowable amount of heat to be generated. If the amount of the heat generated by the heat generating member 10 further increases within the allowable range, the liquid refrigerant 8a will slightly increase. However, the rise in the temperature of the liquid refrigerant 8a will result in an increase in the internal pressure of the cooling vessel, and the gasified refrigerant 8c further begins to more toward the liquid refrigerant reservoir 6. Thus the gasified refrigerant 8c will be liquefied at the condensing pipe 5 and then led into the reservoir 6. In accordance with the change in the amount of liquid refrigerant to be added to the reservoir 6, the expansible member 7 expands to

secure a necessary space therein.

If the liquid refrigerant 8a is changed to its gaseous state and released from the cooling vessel, the quantity of the liquid refrigerant 8a in the cooling vessel will decrease. This causes an increase in the condensing area of the condenser, so that the cycle of boiling and condensation will be repeated with increased intensity and the temperature of the liquid refrigerant 8a will stop rising. As a result, the temperature of the liquid refrigerant 8a will be maintained at a level which is slightly higher than the boiling point of the refrigerant and the internal pressure of the cooling vessel will reach a level which is slightly higher than atmospheric pressure.

The aforementioned description refers to an operation in which the amount of heat generated by the heat generating member 10 increases from zero to a maximum value. Conversely, if the amount of heat generated by the heat generating member 10 is reduced from its maximum value to zero, the temperature of the liquid refrigerant 8a will show a decrease depending upon a reduction in the amount of generated heat. This will cause a reduction in the internal pressure of the cooling vessel, with the result that the liquid refrigerant 8b will pass from the reservoir 6 to the cooling vessel so that the expansible member 7 is compressed and the condensing of effective area of the condenser will be reduced. This will automatically maintain the temperature of the liquid refrigerant 8a at a level near its boiling point and will maintain the internal pressure of the cooling vessel at a level near atmospheric pressure.

As will be apparent from the foregoing explanation, the invention is characterized by the provision of the expansible member enclosing the opening portion of the reservoir with an appropriate volume. By the expansion

and compression of this member in response to the liquid refrigerant entering the reservoir 6, the inside of the cooling vessel can be always maintained at substantially atmospheric pressure without a communication between the reservoir and the atmosphere. Furthermore, by the provision of the expansible member, no liquid refrigerant flows out even if the cooling apparatus is tilted, inverted or vibrated. Since the internal pressure is maintained at atmospheric pressure at all times, the liquid refrigerant is prevented from escape to the outside from the cooling vessel. No discharge or escape of the liquid refrigerant from the cooling vessel is, of course, advantageous for a good cooling performance for a long time.

Fig. 2 shows another embodiment of the present invention in which the cooling vessel is constructed such that the refrigerant may circulate through a relatively short gas pipe 2, a condenser 3 and a relatively long return pipe 4, and that a condenser pipe 5 has one end terminating at an upper portion of the return pipe 4 and the other end terminating at a bottom portion of the reservoir 6.

With this structure of the cooling vessel, the gaseous refrigerant 8c and the liquid refrigerant 8a pass together from the lower portion to the upper portion of the condenser 3 at a relatively high speed. The embodiment of Fig. 2 is advantageous in that the condenser pipe 5 may have a relatively small condensation capacity since the refrigerant to be fed into the reservoir 6 must pass through the condenser 3 by which most of the gaseous refrigerant is condensed and liquefied before reaching the condensing pipe 5. Moreover, the gas pipe is short and the gaseous refrigerant 8c is liquefied in the condenser 3 as soon as it is released from the evaporator 1. This is effective to reduce space occupied by the gaseous

refrigerant 8c in the cooling vessel. This, in turn, minimizes the quantity of liquid refrigerant 8a which may be discharged from the cooling vessel to the outside. As a result, it is possible to reduce the volume of the liquid refrigerant reservoir 6.

Fig. 3 shows another embodiment of the present invention in which the gas pipe 2 is connected to both the condenser 3 and the return pipe 4. The refrigerant 8a is circulated from and to the evaporator 1 through the gas pipe 2 and the return pipe 4. On the other hand, the refrigerant 8c is led through the condenser 3 and the condensing pipe 5 to the reservoir 6. This embodiment differs from that of Fig. 2 in the structure of the cooling vessel but achieves substantially the same effects.

Fig. 4 shows another embodiment of the present invention in which the evaporator, gas pipe, condenser and return pipe are combined into the single cooling vessel 12, and this cooling vessel 12 performs the function of a condenser in all the parts thereof. The apparatus of Fig. 4 has substantially the same advantages as mentioned above and is more advantageous when the heat generating member is large in size.

Although the embodiments shown in Figs. 2, 3 and 4 differ from the embodiment of Fig. 1 in the circulating system of the refrigerant, all of them act automatically to effect adjustments of the condensing area and maintain the temperature of the liquid refrigerant 8a at its boiling point, as is the case with the embodiment shown in Fig. 1.

Other embodiments of the invention are shown in Fig. 5 and Fig. 6. These embodiments differ from those shown in Figs. 1 through 4 in the arrangements of the condensing pipe and the evaporator, but do not differ in the structure of the cooling vessel. Although the embodiments shown in Figs 5 and 6 will be described, for the purpose

of illustration, as using the same type of cooling vessel as in Fig. 1, other types of cooling vessels can, of course, be used.

In the embodiment shown in Fig. 5 the condensing pipe 5 connects the lower portion of the reservoir 6 to the lower portion of the cooling vessel. Since the gaseous refrigerant 8c does not exist at the lower portion in the cooling vessel, the gaseous refrigerant is prevented from directly entering the liquid refrigerant reservoir 6. Accordingly, a pipe having a very small condensation capability can by used as the condensing pipe 5, so that a cooling apparatus of stable cooling operation can be constructed without a complicated configuration.

Fig. 6 shows another embodiment of the invention in which the heat generating member 10 such as a semiconductor element is placed outside the evaporator 1 and in heat transferring relationship with the evaporator wall, so that the heat of the heat generating member will be transferred through the evaporator 1 and the liquid refrigerant in the evaporator will be boiled. This arrangement facilitates maintenance of the heat generating member. In the embodiments shown and described above, the condenser 3 and the condensing pipe 5 are shown as directly transferring heat to the atmosphere. It is to be understood that the invention is not limited to this type of external coolant and its circulating system, and that water may be used to forcibly cool the outside of these members. Also as shown in Fig. 6, the gaseous refrigerant 8c in the condenser may be forcibly cooled by means of a cooling fan 14.

Furthermore, the embodiments mentioned above are shown as containing sealing liquid 9 in the reservoir 6, this is not essential in case where the liquid refrigerant 8b is immiscible with the gas 11.

In case the sealing liquid is removed, the liquid refrigerant reservoir 6 can be constructed with small

size. Conversely, it is also possible to fill the sealing liquid in the space enclosed by the expansible number 7 if this member is constructed to be able to expand in response to the amount of liquid refrigerant entering the reservoir 6.

Since certain changes in the apparatus embodied in the invention herein may be made without departing from its scope, it is intended that all matters contained in the above description shall be considered as illustrative and not in a limiting sense.

CLAIMS

1. A closed type boiling cooling apparatus, characterized by

(a) a boiling refrigerant (8);

(b) a cooling vessel including an evaporator section (1) containing said boiling refrigerant (8) and adapted to transfer the heat of a heat generating member (10) to the refrigerant (8), and a condenser section (3) completely filled with the refrigerant (8) when no cooling or only slight cooling of the heat generating member (10) is effected, said condenser section (3) being adapted to liquefy the refrigerant (8) which has been changed to its gaseous state by the heat transferred from the heat generating member (10);

(c) a liquid refrigerant reservoir means (6) for storing a body of the refrigerant (8) which does not directly take part in the cooling operation when such operation is performed;

(d) an expansible means (7) enclosing an opening portion of the reservoir means (6) and adapted to expand depending upon the change in the amount of the liquid refrigerant (8) led into the reservoir means (6); and

(e) a communicating means (5) connecting said cooling vessel to said liquid refrigerant reservoir means (6), which leads the increased amount of the refrigerant (8) from the cooling vessel into said reservoir

means (6) in the liquid state when the heat generating member (10) generates an increased amount of the heat.

2. A closed type boiling cooling apparatus, characterized by

(a) a boiling refrigerant (8);

(b) a cooling vessel including an evaporator section (1) containing said boiling refrigerant (8) and adapted to transfer the heat of a heat generating member (10) to the refrigerant (8), and a condenser section (3) for liquefying the refrigerant (8) which has been changed to its gaseous state;

(c) a liquid refrigerant reservoir means (6) for storing a body of the refrigerant (8), said reservoir means (6) containing a predetermined quantity of a liquid means (9) of a lower specific gravity than the boiling refrigerant (8), said liquid means (9) being immiscible with the boiling refrigerant (8) and being an aqueous solution;

(d) an expansible means (7) enclosing an opening portion of the reservoir means (6) and adapted to expand to an extent depending upon the amount of liquid refrigerant (8) stored in the reservoir means (6); and

(e) a communicating means (5) connecting said cooling vessel to said liquid refrigerant reservoir means (6), which leads the greater amount of the refrigerant (8) from the cooling vessel into said reservoir means (6) in the liquid state when the heat generating means (10) generates a larger amount of heat.

3. A closed type boiling cooling apparatus, characterized by

(a) a boiling refrigerant (8);

(b) a cooling vessel including an evaporator section (1) containing said boiling refrigerant (8) and adapted to transfer the heat of a heat generating member (10) to the refrigerant (8), and a condenser section (3) for liquefying the refrigerant (8) which has been changed into its gaseous state;

(c) a liquid refrigerant reservoir means (6) for storing a body of the refrigerant (8) which does not directly take part in the cooling operation when such operation is performed;

(d) an expansible means (7) enclosing an opening of the reservoir means (6) and adapted to provide an appropriate volume above the surface of the liquid refrigerant (8) in the reservoir means (6) and said enclosing expansible means (7) being adapted to expand in response to the amount of liquid

refrigerant (8) stored in the reservoir means (6); and

(e) a communicating means (5) connecting said cooling vessel to said liquid refrigerant reservoir means (6), which leads the greater amount of the refrigerant (8) from the cooling vessel into said reservoir means (6) in the liquid state when larger amounts of heat are generated by the heat generating member, said communicating means (5) having a downflow passage through which the refrigerant (8) flows downwardly from the cooling vessel to the reservoir (6).

4. A closed type boiling cooling apparatus as claimed in one of claims 1 to 3, characterized in that the heat generating member (10) is disposed in the evaporator section (1) of the cooling vessel.

5. A closed type boiling cooling apparatus as claimed in one of claims 1 to 4, characterized in that said communicating means (5) includes a condensing pipe connecting the cooling vessel to the bottom of the liquid refrigerant reservoir means (6) so that the gaseous refrigerant (8) from the cooling vessel can be liquified and then led into the liquid refrigerant reservoir means (6).

6. A closed type boiling cooling apparatus as claimed in one of claims 1 to 5, characterized in that said communicating means (5) includes a condenser pipe having a first end terminating at the cooling vessel and a second end terminating in a lower end of the liquid reservoir means (6), and wherein said condensing pipe is arranged such that said second end is disposed at a position below said first end.

7. A closed type boiling cooling apparatus as claimed in one of claims 1 to 6, characterized in that a first pipe means (2) is provided for connecting said evaporator section (1) to said condenser section (3), a second pipe means (4) is provided for connecting said condenser section (3) to said evaporator section (1), and wherein said communicating means (5) includes a condensing pipe extending between a portion of said first pipe means (2) and said liquid refrigerant reservoir means (6).

8. A closed type boiling cooling apparatus as claimed in one of claims 1 to 6, characterized in that a first pipe means (2) is provided for connecting said evaporator section (1) to said condenser section (3), a second pipe means (4) is provided for connecting said condenser section (3) to said evaporator section (1), and wherein said communicating means (5) includes a condensing

pipe extending between a portion of said second pipe means (4) and said liquid refrigerant reservoir means (6).

9. A closed type boiling cooling apparatus as claimed in one of claims 1 to 6, characterized in that a pipe means is provided for connecting an upper portion of the evaporator section (1) to a lower portion thereof, and wherein said coummunicating means (5) includes a condensing pipe extending between the top portion of the condenser section (1) and the bottom portion of the liquid refrigerant reservoir means (6).

10. A closed type boiling cooling apparatus as claimed in one of claims 1 to 9, characterized in that means (14) are arranged at the condenser section (3) for forcibly cooling the gaseous refrigerant (8).

11. A closed type boiling cooling apparatus as claimed in one of claims 1 to 10, characterized in that the space between the surface of the liquid refrigerant (8) in the reservoir means (6) and the enclosing expansible means (7) is filled with inactivated gas (11).

12. A closed type boiling cooling apparatus as claimed in one of claims 1 to 11, characterized in that said liquid refrigerant reservoir means (6) contains an

aqueous solution (9) of at least one of the materials selected from the group consisting of polyhydric alcohols, polysaccharides, polyvinyl alcoholes, and glucose.

13. A closed type boiling cooling apparatus as claimed in one of claims 1 to 12, characterized in that said boiling refrigerant (8) is a liquid refrigerant which is a halogenated hydrocarbon.

14. A closed type boiling cooling apparatus as claimed in one of claims 1 to 3 and 5 to 13, characterized in that said heat generating member (10) is disposed outside the evaporator section (1) in heat transferring relationship with the liquid refrigerant (8) in the evaporator section (1).

15. A closed type boiling cooling apparatus, characterized by

(a) a boiling refrigerant (8);

(b) a cooling vessel (12) containing said boiling refrigerant (8) and adapted to transfer the heat of a heat generating member (10), said cooling vessel (12) being provided on its outer surface with a heat exchanger means;

(c) a liquid refrigerant reservoir means (6) for storing a body of the refrigerant (8) which does not directly take part in the cooling operation when such

operation is performed;

(d) an expansible means (7) adapted to enclose an opening of said liquid refrigerant reservoir means (6) with an appropriate volume between the surface of the liquid refrigerant (8) in the reservoir means (6) and an inner wall of said expansible means (7), said expansible means (7) being adapted to expand to an extent depending upon the amount of the liquid refrigerant (8) led into the reservoir means (6); and

(e) a communicating means (5) connecting said cooling vessel (12) with said liquid refrigerant reservoir means (6), said communicating means (5) having a downflow portion of a condenser pipe means through which gaseous refrigerant is permitted to flow downwardly from the cooling vessel (12) to the liquid refrigerant reservoir (6), whereby a larger amount of gaseous refrigerant (8) is led into said communicating means and led in the liquid state into the liquid refrigerant reservoir means (6) as the heat generating member (10) generates a greater amount of heat.

PS/Ug

FIG. 1a

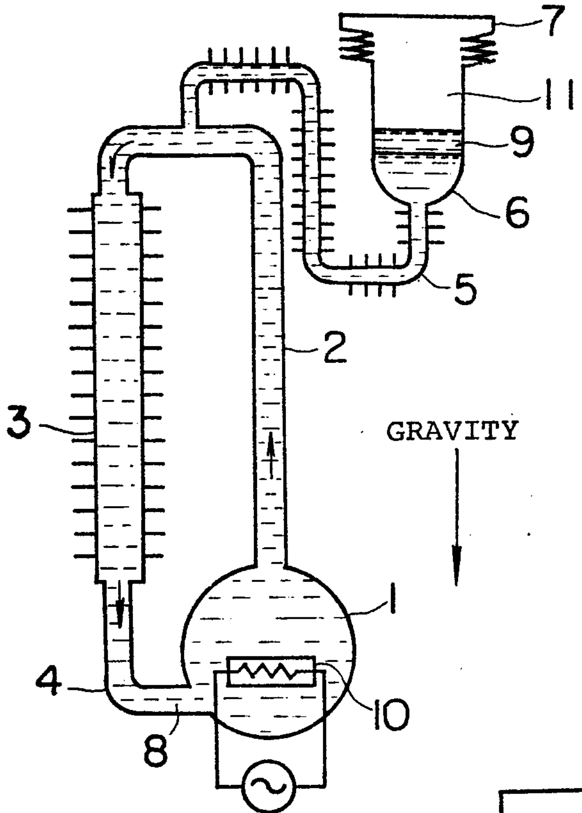


FIG. 1b

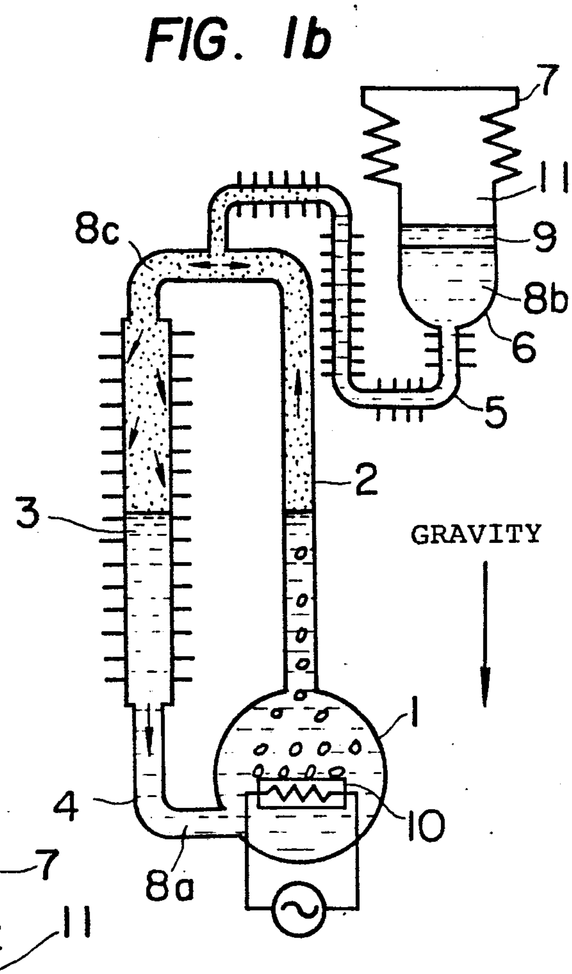


FIG. 2

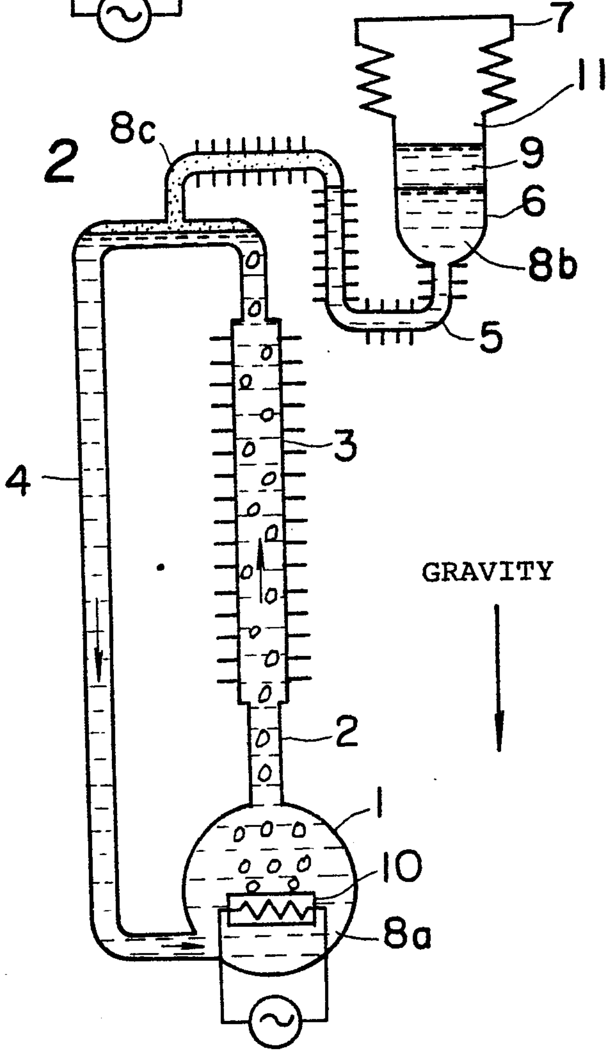

FIG. 3

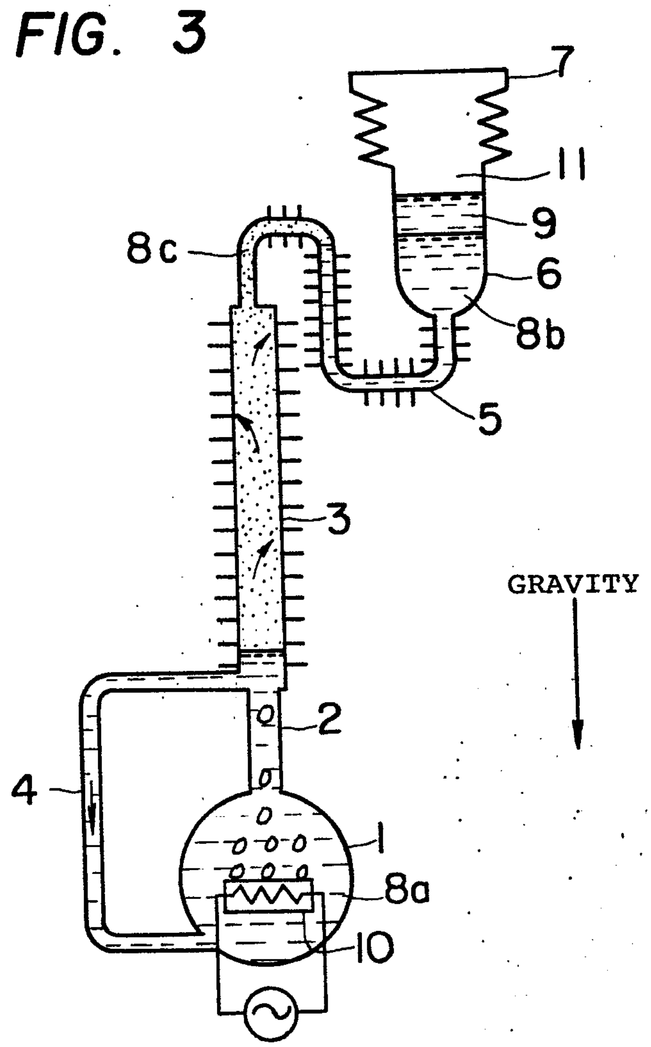


FIG. 4

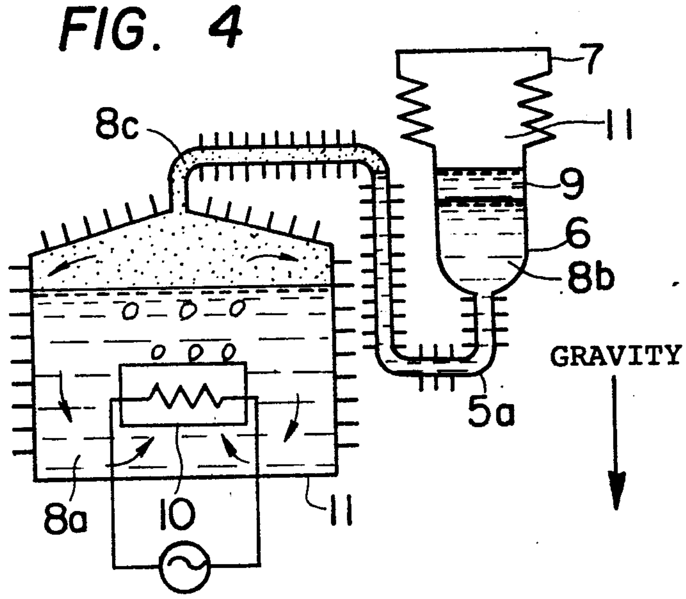

0000786

3/3

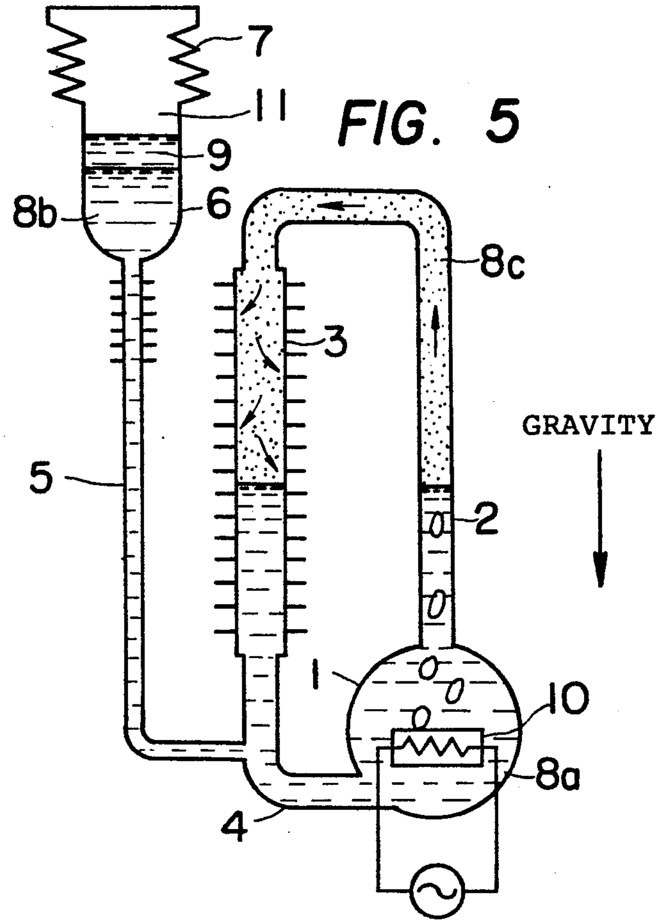


FIG. 5

FIG. 6

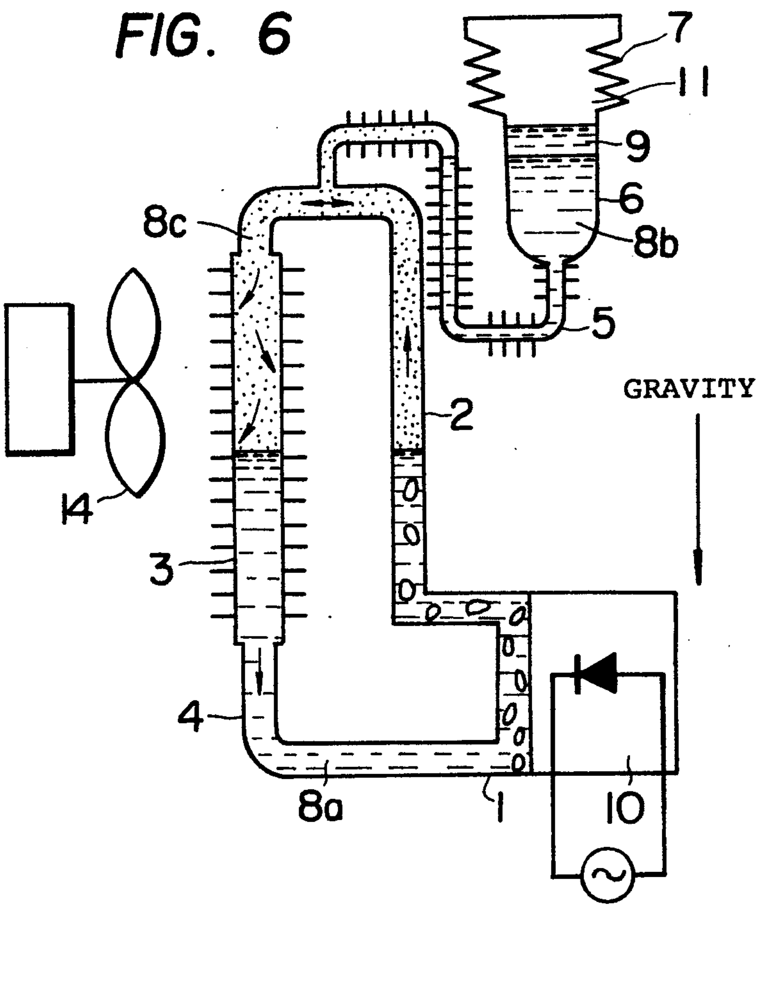

0000786

European Patent Office

# EUROPEAN SEARCH REPORT

Application number

EP 78 10 0639

## DOCUMENTS CONSIDERED TO BE RELEVANT

| Category | Citation of document with indication, where appropriate, of relevant passages | Relevant to claim |
|---|---|---|
| D | US - A - 3 682 237 (ISLO)<br>* Column 1, lines 56-68; column 2, lines 1-15, 49-66; figures * | 1-4, 10,11, 15 |
| | US - A - 2 961 476 (MASLIN)<br>* Column 2, lines 62-72; column 3, lines 6-23; column 5, lines 21-75; column 6, lines 1-40; figures 1 and 2 * | 1-4,11, 13,15 |
| | ELEKTRIE, vol. 25, no. 8, August 1971, Berlin, TITKIN S.A. "Verdampfungskühlung von Siliziumleistungsdioden mit einseitiger Wärmeabführung", page U160.<br>* Page U160; figure 2 * | 1-4,15 |
| | DE - A - 2 642 160 (HITACHI)<br>* In its entirety * | 1-10, 12-15 |
| | FR - A - 1 319 387 (CHAUSSON)<br>* Page 3, left-hand column, lines 40-53; figure 7 * | 1-4,15 |
| | DE - C - 659 848 (BESAG)<br>* Page 1, lines 1-13; figures 1-3 * | 1-3,15 |

./.

CLASSIFICATION OF THE APPLICATION (Int. Cl.²)

F 25 B 23/00
F 28 D 15/00
H 01 L 23/42
H 01 F 27/18

TECHNICAL FIELDS SEARCHED (Int.Cl.²)

F 25 B 23/00
F 28 D 15/00
F 25 D 9/00
H 01 L 23/42
H 01 F 27/18

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

℘ The present search report has been drawn up for all claims

| Place of search | Date of completion of the search | Examiner |
|---|---|---|
| The Hague | 10-11-1978 | HERZOG |

EPO Form 1503.1 06.78

0000786

European Patent Office

# EUROPEAN SEARCH REPORT

Application number

EP 78 10 0639

-2-

| Category | Citation of document with indication, where appropriate, of relevant passages | Relevant to claim | CLASSIFICATION OF THE APPLICATION (Int. Cl.²) |
|---|---|---|---|
| | DOCUMENTS CONSIDERED TO BE RELEVANT | | |
| | DE - B - 2 344 063 (GOETZ)<br>* Column 1, lines 4-22; column 2, lines 24-68; column 3, lines 1-5; figures 1-3 *<br>-- | 1-3,15 | |
| A | DE - A - 2 412 631 (HITACHI) | 1-3,15 | |
| A | CH - A - 95 902 (HAEFELY) | 1-3,15 | TECHNICAL FIELDS SEARCHED (Int. Cl.²) |
| A | DE - C - 723 857 (DORNIER-WERKE)<br>----- | 1-3,15 | |

EPO Form 1503.2 06.78

European Patent Office

# EUROPEAN SEARCH REPORT

Application number

EP 78 30 0153

| DOCUMENTS CONSIDERED TO BE RELEVANT | | | CLASSIFICATION OF THE APPLICATION (Int. Cl.²) |
|---|---|---|---|
| Category | Citation of document with indication, where appropriate, of relevant passages | Relevant to claim | |
| DA | GB - A - 1 468 156 (IMP. CHEM. IND.)(cited in the application)<br>* Page 1, line 6 - page 2, line 38 *<br>---- | 1 | C 07 C 103/44<br>C 07 C 127/19<br>A 61 K 31/16<br>A 61 K 31/17//<br>C 07 C 97/10<br>C 07 C 103/42 |

TECHNICAL FIELDS SEARCHED (Int.Cl.²)

C 07 C 103/44
C 07 C 127/19

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 14-11-1978 | PAUWELS |

EPO Form 1503.1 06.78